# EUROPÄISCHE PATENTSCHRIFT

(11) **EP 1 649 735 B1**
(45) Veröffentlichungstag und Bekanntmachung des Hinweises auf die Patenterteilung: **03.11.2010**
(21) Anmeldenummer: 04741444.6
(22) Anmeldetag: 05.04.2004
(51) Int. Cl.: H05K 5/00, H05K 7/14

(54) **HALTEVORRICHTUNG**
RETAINER DEVICE
DISPOSITIF DE RETENUE

(30) Priorität: 29.07.2003 DE 10334623
(43) Veröffentlichungstag der Anmeldung: 26.04.2006
(73) Patentinhaber: Gigaset Communications GmbH, 81379 München (DE)
(72) Erfinder: HÜNTING, Ralf, 46395 Bocholt (DE); SCHILLING-FRENK, Hans, 46414 Rhede (DE)
(74) Vertreter: Michalski Hüttermann & Partner Patentanwälte
(86) Internationale Anmeldenummer: PCT/EP2004/050438
(87) Internationale Veröffentlichungsnummer: WO 2005/013654

(56) Entgegenhaltungen:
- DE-A- 10 058 552
- DE-U- 29 623 997
- US-A- 5 742 359
- US-A- 6 148 183
- US-A1- 2002 092 749

## Beschreibung

Die Erfindung betrifft eine Haltevorrichtung zum Halten zumindest einer Baugruppe an einer Leiterplatte, welches zumindest ein Schalterelement aufweist. Ferner betrifft die Erfindung ein elektronisches Gerät mit einer entsprechenden Haltevorrichtung.

Haltevorrichtungen werden in verschiedenen Bereichen der Elektronik eingesetzt, um bestimmte Baugruppen an Trägerelementen, wie beispielsweise Leiterplatten mit Schalterelementen, zu halten. So finden Haltevorrichtung Anwendung in technischen Geräten, wie beispielsweise Mobilfunkgeräten, Laptops, Notebooks, PDAs (PDA = persönlicher digitaler Assistent), Smartphones, die eine Kombination aus einem kleinen tragbaren Computer und einem Mobiltelefon darstellen, sowie Organizern. Trägerelemente, wie Leiterplatten, können mit oberflächenmontierbaren Bauelementen bestückt werden. Beispielsweise werden SMD-Schalter (SMD = surface mount device) auf die Leiterplatte aufgebracht. Diese SMD-Schalter werden durch Tasten oder Hebel, die ein Nutzer bedienen kann, betätigt. Die Tasten oder Hebel sind an Bauteilen, die um die Leiterplatte herum angeordnet sind, befestigt. So werden beispielsweise bei einem Mobilfunkgerät Tasten für die Lautstärkeeinstellung in entsprechenden Aussparungen in den Gehäuseteilen, beispielsweise an den Seiten der Ober- und/oder Unterschale des Mobilfunkgeräts, befestigt bzw. geführt. Die entsprechenden SMD-Schalter sind in der Regel am Rand der Trägerelemente gesetzt, so dass sie durch die Tasten betätigt werden können.

Es ist bekannt, dass durch Haltevorrichtungen bestimmte Baugruppen an einem Trägerelement befestigt werden. So werden beispielsweise bei einem Mobilfunkgerät Displaykomponenten durch eine Haltevorrichtung, einem sogenannten Display-Halter, an der Leiterplatte gehalten. Die Haltevorrichtungen können an Bohrungen in der Trägerelemente befestigt werden. Ferner gibt es Haltevorrichtungen, die Klemmverbindungen aufweisen, die die Trägerelemente, insbesondere die Leiterplatte, seitlich umfassen.

Nachteilig bei den bekannten Haltevorrichtungen ist, dass diese lediglich zum Halten einer Baugruppe an dem Trägerelementen genutzt werden können. Schalterelemente auf der Leiterplatte müssen durch separat angeordnete Tasten betätigt werden. D. h. die Tasten sind an separaten Bauteilen, die in der Nähe der Trägerelemente liegen, angeordnet. Die Tasten müssen nachträglich durch Handmontage oder durch einen Setzautomaten an den separate Bauteilen montiert werden. Die genaue Zuordnung der Tasten zu Schalterelementen auf dem Trägerelement bzw. auf der Leiterplatte ist schwierig und erfordert einen erhöhten Arbeitsaufwand. Die Bauteile, die um das Trägerelement herum angeordnet sind, müssen spezielle Aussparungen oder Aufnahmen aufweisen, um die Taste sicher zu halten. Nachteilig ist weiterhin bei einer Taste, die beispielsweise für die Lautsprecherbenutzung bei einem Mobilfunkgerät vorgesehen ist, dass diese bei der Lautsprecherbenutzung ein Rasseln im Gehäuse erzeugt, wenn die Taste als separates Bauteil in Aussparungen im Gehäuse angeordnet ist.

Aus dem Dokument US 6 148 183 A ist in Verbindung mit einem zugehörigen Trägerelement eine Schaltervorkehrung für ein elektronisches Gerät bekannt, das als eine Baugruppe ein Displaymodul hat, welchem zum Halten an ein Trägerelement eine Haltevorrichtung zugeordnet ist, die im vorliegenden Fall durch einen Halterahmen gebildet ist. Die Schaltervorkehrung hat Taster, die wie die Haltevorrichtung für das Displaymodul als separate Teile verbaut sind.

Aus dem Dokument US 5 742 359 A ist ein Trägerelement mit einem darauf angeordneten Schalterelement bekannt, das mit Hilfe eines separaten Tasters betätigt wird.

Aus dem Dokument DE 296 23 997 U ist Entsprechendes wie aus dem Dokument US 5 742 359 A bekannt, mit dem Unterschied, dass hier der Taster integraler Bestandteil eines Gehäuseteils ist.

Aufgabe der Erfindung ist es, eine Haltevorrichtung zum Halten zumindest einer Baugruppe an einer Leiterplatte welches zumindest ein Schalterelement aufweist, zu schaffen, die einfach an das Trägerelement montiert werden kann und durch die das zumindest einen Schalterelements des Trägerelements betätigt werden kann.

Diese Aufgabe wird durch eine Haltevorrichtung zum Halten zumindest einer Baugruppe an einer Leiterplatte, welches zumindest ein Schalterelement aufweist, wobei an der Haltevorrichtung wenigstens eine bewegliche Taste einstückig angeformt ist, und wobei die Taste im montierten Zustand der Haltevorrichtung an dem Trägerelement dem zumindest einen Schalterelement des Trägerelements in der Weise zugeordnet ist, dass durch eine Betätigung der Taste das zumindest eine zugeordnete Schalterelement betätigbar ist, gelöst.

Dadurch, dass Haltevorrichtung und Taste einstückig ausgebildet sind, ist es nicht mehr notwendig nachträglich dem Schalterelement eine Taste, die an einem separaten Bauteil befestigt wäre, zuzuordnen. Dies erspart zum einen Materialkosten, zum anderen erspart es Zeit bei der Zuordnung der Taste zu dem entsprechenden Schalterelement. Durch die Montage der erfindungsgemäßen Haltevorrichtung ist die Taste direkt mitmontiert. Ferner werden die Montagekosten deutlich niedriger gehalten, als bei einer Ausführungsform einer Haltevorrichtung, bei der keine Taste angeformt ist.
Dadurch, dass die Haltevorrichtung die Taste aufweist, kann die Taste dem zumindest einen Schalterelements auf dem Trägerelement bereits bei der Montage der Haltevorrichtung an dem Trägerelement präzise zugeordnet werden. Eine Haltevorrichtung für eine Baugruppe, wie beispielsweise ein technisches Gerät, die eine Taste aufweist, hat den Vorteil, dass sie zum einen die Funktion des Haltens der Baugruppe erfüllt und zum anderen zum Betätigen zumindest eines Schalterelements auf dem Trägerelement dient. Durch das Anbringen der Haltevorrichtung an dem Trägerelement kann automatisch die zumindest eine Taste dem zumindest einen Schalterelement auf dem Trägerelement zugeordnet werden. Die Taste ist derart an der Haltevorrichtung angeordnet, dass nach dem Anbringen der Haltevorrichtung an dem Trägerelement, die Taste präzise vor dem Schalterelement sitzt, so dass dieser durch die Taste betätigt werden kann. Durch die einstückige Ausgestaltung der Haltevorrichtung und der Taste lässt sich die Taste besonders leicht und präzise dem entsprechenden Schalterelement auf dem Trägerelement zuordnen. Die zumindest eine Taste ist derart an der Haltevorrichtung ausgebildet, dass nach dem Anbringen der Haltevorrichtung an dem Trägerelement die Taste exakt vor dem entsprechenden zugeordneten Schalterelement angeordnet ist, dass ein Betätigen des Schalterelements möglich ist. Die Haltevorrichtung mit Taste kann sehr einfach an dem Trägerelement befestigt werden. Dies kann beispielsweise durch Schrauben, die durch Bohrungen in der Haltevorrichtung und in dem Trägerelement geführt werden, erfolgen. Ferner kann die Haltevorrichtung an dem Trägerelement durch eine stoffschlüssige Verbindung abgebracht werden. Besonders geeignet ist eine Klemmverbindung der Haltevorrichtung an dem Trägerelement. Die Haltevorrichtung weist idealerweise an zumindest zwei Seiten Klemmelemente auf, die zwei gegenüberliegende Bereiche des Trägerelements hintergreifen. Die Haltevorrichtung mit der zumindest einen Taste kann idealerweise ein Spritzgussteil sein. Als Trägerelemente sind alle möglichen Bauteile geeignet, an die zumindest ein Schalterelement, durch dessen Betätigung ein Prozess gesteuert werden kann, angeordnet werden kann.

Weiterhin vorteilhaft ist es, wenn die wenigstens eine Taste federnd an der Haltevorrichtung angeformt ist. Hierdurch lässt sich die Taste einfach in Richtung des Schalterelements auf dem Trägerelement bewegen. Die Federung sorgt für eine Rückführung der Taste in eine zuvor definierte Ausgangsstellung. Die Federung ist derart ausgebildet, dass der Weg der Taste zu dem entsprechenden Schalter auf dem Trägerelement zu dessen Betätigung mühelos zurückgelegt werden kann. Durch geeignete Materialwahl der Haltevorrichtung und der Taste kann die Taste federnd an der Haltevorrichtung gehalten sein.

Besonders bevorzugt ist eine erfindungsgemäße Haltevorrichtung, bei der das Trägerelement eine Leiterplatte ist. Schalterelemente sind insbesondere an Leiterplatten angeordnet. Leiterplatten sind besonders geeignet, da die Haltevorrichtung eine Leiterplatte an den Seiten leicht durch entsprechende Klemmelemente der Haltevorrichtung hintergreifen kann. Daher ist es vorteilhaft, wenn die Haltevorrichtung Befestigungselemente, insbesondere Schnappelemente, aufweist, durch die die Haltevorrichtung an dem Trägerelement befestigbar ist. Die Befestigungselemente sind federnd an der Haltevorrichtung angeordnet. Befestigungselemente, wie Schnapp- oder Klemmverbindungen, die am Rand der Leiterplatte angeklemmt sind, eignen sich besonders gut, um die Haltevorrichtung an dem Trägerelement bzw. der Leiterplatte zu halten. Die Haltevorrichtung wird durch die Schnappelemente an das Trägerelement angeklipst, wodurch es fest an diesem sitzt.
Denkbar ist auch, dass die zumindest eine Taste an einem Befestigungselement der Haltevorrichtung angeordnet ist. Da die Schalterelemente häufig am Rand des Trägerelement, insbesondere bei einer Leiterplatte, angeordnet sind, eignen sich diese Befestigungselemente besonders gut zum Anbringen der zumindest einen Taste. Es ist denkbar, dass mehrere Tasten an der Haltevorrichtung bzw. an einem Befestigungselement der Haltevorrichtung sitzen, so dass mehrere Schalterelemente betätigt werden können.

Bevorzugt ist ferner eine Haltevorrichtung, bei der das zumindest eine Schalterelement an einem seitlichen Rand des Trägerelements angeordnet ist. Einem seitlich angeordnetem Schalterelement lässt sich besonders leicht die Taste einer Haltevorrichtung zuordnen. Die wenigstens eine Taste ist in Anpassung der Anordnung des zumindest einen Schaltelements an dem seitlichen Rand des Trägerelements vorteilhafterweise an einem seitlichen Rand der Haltevorrichtung angeordnet. Hierdurch kann die Verbindung zwischen Taste und Haltevorrichtung gering gehalten werden, wodurch einerseits Material- und Herstellkosten niedrig gehalten werden können, andererseits kann durch eine kurze Verbindung eine gute Federwirkung erzielt werden.

Ferner ist eine Haltevorrichtung vorteilhaft, bei der die Taste und die Haltevorrichtung aus Kunststoff, insbesondere aus transparentem Kunststoff, ausgebildet sind. Zum einen lässt sich die Haltevorrichtung mit der Taste besonders einfach durch ein Spritzgussverfahren herstellen. Zum anderen kann die Taste auf einfache Art und Weise federnd an der Haltevorrichtung angeordnet sein, wenn die Haltevorrichtung und die Taste aus ein und demselben Kunststoff hergestellt sind. Idealerweise ist der Kunststoff transparent. Hierdurch lässt sich die Taste einfach durchleuchten, wodurch sie für einen Nutzer leicht erkennbar und bedienbar wird.

Bevorzugt ist ferner eine Haltevorrichtung, bei der die Taste und/oder die Haltevorrichtung zumindest eine Vorrichtung zur Führung eines Lichtleiters aufweisen. Hierdurch kann leicht ein Lichtleiter angeordnet werden, wodurch die Baugruppe, die durch die Haltevorrichtung gehalten wird, und die zumindest eine Taste beleuchtet werden können. Vorrichtungen für Lichtleiter ermöglichen eine bessere gezielte Beleuchtung der Taste bzw. der entsprechenden Baugruppe, wie beispielsweise eines Displays. Der Einbau eines Lichtleiters wird durch vorhandene Vorrichtungen zur Führung des Lichtleiters erheblich erleichtert.

Die Erfindung betrifft ferner ein elektronisches Gerät, welches zumindest ein Schalterelement aufweist, mit einer Haltevorrichtung zum Halten einer Baugruppe, insbesondere von Displaykomponenten, an dem Trägerelement, wobei das elektronische Gerät eine zuvor beschriebene erfindungsgemäße Haltevorrichtung aufweist. Der Einsatz einer erfindungsgemäßen Haltevorrichtung in einem elektronischen Gerät hat den Vorteil, dass die Taste zur Betätigung eines Schalterelements auf einem Trägerelement bereits bei der Montage der Haltevorrichtung dem Schalterelement zugeordnet ist. Eine nachträgliche Handmontage oder eine Montage durch einen Setzautomaten der Taste ist nicht erforderlich. Dies erspart bei der Montage Zeit und Kosten. Ferner kann die Taste dem Schalterelement exakter zugeordnet werden, als dies bei einer nachträglichen Montage der Taste möglich ist. Dadurch, dass die Taste fest mit einer Haltevorrichtung verbunden ist, sitzt die Taste fester, als eine Taste, die in einer Aussparung oder Führung eines Bauteils, wie eines Gehäuses, befestigt ist, welches um das Trägerelement herum angeordnet ist.

Dabei hat das elektronische Gerät eine Leiterplatte als Trägerelement. Die erfindungsgemäße Haltevorrichtung lässt sich, wie bereits zuvor beschrieben besonders gut an einer Leiterplatte befestigen. Elektronische Geräte weisen in der Regel Leiterplatten auf, an denen Schalterelemente angeordnet sind. Zum Betätigen dieser Schalterelemente ist eine erfindungsgemäße Haltevorrichtung besonders geeignet.

Bevorzugt ist das elektronische Gerät ein Mobilfunkgerät, ein PDA, ein Smartphone, ein Notebook, ein Laptop oder ein Organizer. Diese elektronischen Geräte weisen Tasten zum Betätigen von Schalterelementen auf Leiterplatte auf. Durch eine erfindungsgemäße Leiterplatte wird die Montage von Tasten vereinfacht und kostengünstiger. Ein Rasseln der Tasten beim Betrieb des jeweiligen elektronischen Gerätes wird durch die erfinderische Anordnung der Taste an der Leiterplatte unterbunden.

Sämtliche zu der Haltevorrichtung genannten Einzelheiten beziehen sich auch auf das elektronische Gerät und umgekehrt.

Bevorzugte Ausführungsformen der vorliegenden Erfindung werden nachfolgend unter Bezugnahme auf die beiliegenden Zeichnungen näher erläutert. Es zeigen:
- Figur 1: eine Draufsicht auf eine erfindungsgemäße Haltevorrichtung mit einer einstückig angeformten Taste, wobei die Haltevorrichtung an einer Leiterplatte befestigt ist;
- Figur 2: eine perspektivische Ansicht einer erfindungsgemäßen Haltevorrichtung, an die eine Taste einstückig angeformt ist.

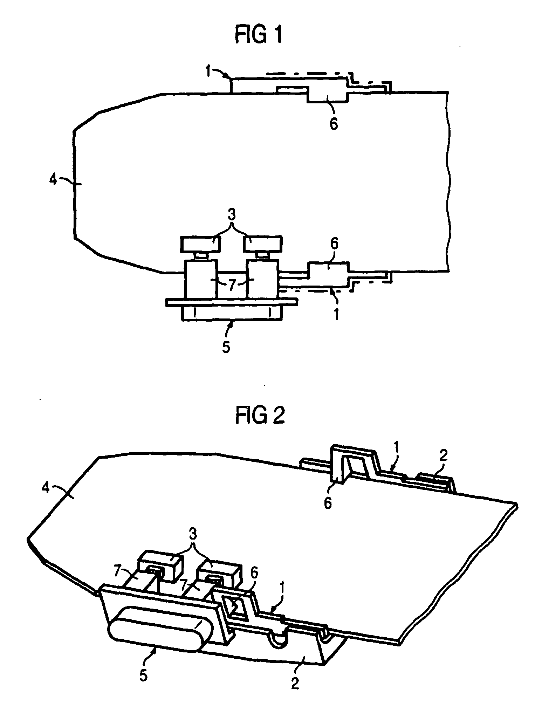

Fig. 1 zeigt eine Draufsicht auf eine erfindungsgemäße Haltevorrichtung 1, die an einem Trägerelement 4, hier eine Leiterplatte, befestigt ist. An der Leiterplatte 4 sind zwei Schalterelemente 3 angeordnet. Die Haltevorrichtung 1 umklammert die Seiten der Leiterplatte 4. Hierfür weist die Haltevorrichtung 1 Befestigungselemente 6, insbesondere Schnappelemente, auf, die an der Haltevorrichtung 1 federnd angeformt sind. Diese Befestigungselemente 6 werden an die Leiterplatte 4 angeklipst, wodurch die Haltevorrichtung 1 lösbar an der Leiterplatte 4 befestigt ist. Die Leiterplatte 4 kann dabei in einer Nut der Haltevorrichtung 1 einliegen, wodurch Haltevorrichtung 1 und Leiterplatte 4 fest aneinander angeordnet sind. Die Haltevorrichtung 1 dient dazu eine Baugruppe 2, in der Regel ein technisches Element, wie beispielsweise ein Display oder eine Blende für ein Display, zu halten. Die Haltevorrichtung 1 kann dabei so ausgebildet sein, dass sie auf einer Seite oder auf beiden Seiten der Leiterplatte 4 eine Baugruppe 2 halten kann. Die Haltevorrichtung 1 weist eine Taste 5 auf, die einstückig mit der Haltevorrichtung 1 ausgebildet ist. Die Taste 5 und die Haltevorrichtung 1 sind idealerweise aus Kunststoff hergestellt. Die Taste 5 weist zwei Elemente 7 zum Betätigen jeweils eines Schalterelements 3 auf. Je nachdem welche Seite der Taste 5 ein Nutzer betätigt, wird einer der beiden Schalterelemente 3 betätigt.

Die Fig. 2 zeigt eine erfindungsgemäße Haltevorrichtung 1, die an einer Leiterplatte 4 befestigt ist, in perspektivischer Ansicht. Die Befestigungselemente 6 der Haltevorrichtung 1 sind an den langen Seiten der Leiterplatte 4 angeklemmt. Die Haltevorrichtung 1 weist dazu Befestigungselemente 6 auf, die federnd an der Haltevorrichtung 1 angeordnet sind. Diese Befestigungselemente 6 werden an die Leiterplatte 4 angeklipst, wodurch die Haltevorrichtung 1 fest an der Leiterplatte 4 sitzt. Die Haltevorrichtung 1 weist idealerweise eine Nut auf, in der die Leiterplatte 4 einliegt. An der Haltevorrichtung 1 ist einstückig eine Taste 5 ausgebildet, die zur Betätigung der beiden auf der Leiterplatte 4 befestigten Schalterelemente 3 dient. Die Taste 5 ist beweglich, insbesondere federnd, an der Haltevorrichtung 1 angeordnet. Idealerweise ist die Taste 5, die zwei Schalterelemente 3 betätigt, kippbar an der Haltevorrichtung 1 angeformt, so dass sie immer nur ein Schalterelement betätigen kann, je nachdem welcher Bereich der Taste 5 von einem Nutzer gedrückt wird. Hierfür ist die Taste 5 derart an der Haltevorrichtung 1 angeordnet, dass die Verbindung von Taste 5 und Haltevorrichtung 1 zwischen den beiden Elementen 7 der Taste 5, die zum Betätigen der Schalterelemente 3 dienen, liegt. Die Verbindung dient dann als Wippe für die Taste 5. In Fig. 2 ist eine Baugruppe 2 gezeigt, die an der Haltevorrichtung 1 sitzt. In diesem Beispiel ist die Baugruppe 2 eine Displaykomponente für ein Mobilfunkgerät.

Die erfindungsgemäße Leiterplatte 1 kann in einem Mobilfunkgerät eingebaut werden. Die Taste 5 ragt an der Seite des Mobilfunkgerätes in entsprechenden Aussparungen in der Ober- und/oder Unterschale des Mobilfunkgerätes heraus, so dass ein Nutzer die Taste 5 durch Drücken betätigen kann. Die Taste 5 und die zugehörigen Schalterelemente 3 dienen beispielsweise zur Lautstärkeregelung. Die Taste 5 kann aus harten oder weichem Material, insbesondere Kunststoff, bestehen. Harte Tasten 5 haben den Vorteil, dass der Hub der Taste 5 zu dem Schalterelement 3 besser ausgenutzt werden kann. Ferner kann bei der Verwendung von harten Material die Taste 5 leichter federnd an der Haltevorrichtung 1 angeformt werden. Die Wertigkeit eines elektronischen Gerätes wird durch eine harte Taste 5 aufgewertet.

Die zumindest eine Taste 5 kann zusätzlich ein Element zum Betätigen des zumindest einen Schalterelements 3 aufweist. Das Element kann einstückig mit der Taste ausgebildet oder als separates Element an der Taste 5 befestigt sein. Das Element dient zur exakten Betätigung des Schalterelements 3 auf der Leiterplatte 4. Dass Element kann beispielsweise ein kleiner Vorsprung, ein sogenanntes Füßchen, an der Taste 5 sein. Das Element kann federnd ausgebildet sein. Das Element ist so an der Taste 5 angeordnet, dass durch dieses das Schalterelement 3 exakt betätigt werden kann.

## Patentansprüche

1. Haltevorrichtung (1) zum Halten zumindest einer Baugruppe (2) an einer Leiterplatte (4), welches zumindest ein Schalterelement (3) aufweist, **dadurch gekennzeichnet, dass** an der Haltevorrichtung (1) wenigstens eine bewegliche Taste (5) einstückig angeformt ist, wobei die Taste (5) im montierten Zustand der Haltevorrichtung (1) an der Leiterplatte (4) dem zumindest einen Schalterelement (3) der Leiterplatte (4) in der Weise zugeordnet ist, dass durch eine Betätigung der Taste (5) das zumindest eine zugeordnete Schalterelement (3) betätigbar ist.

2. Haltevorrichtung (1) nach Anspruch 1, **dadurch gekennzeichnet, dass** die Wenigstens eine Taste (5) federnd an der Haltevorrichtung (1) angeformt ist.

3. Haltevorrichtung (1) nach einem der vorherigen Ansprüche, **dadurch gekennzeichnet, dass** die Haltevorrichtung (1) Befestigungselemente (6), insbesondere Schnappelemente, aufweist, durch die die Haltevorrichtung (1) an der Leiterplatte (4) befestigbar ist.

4. Haltevorrichtung (1) nach einem der vorherigen Ansprüche, **dadurch gekennzeichnet, dass** das zumindest eine Schalterelement (3) an einem seitlichen Rand der Leiterplatte (4) angeordnet ist

5. Haltevorrichtung (1) nach Anspruch 5, **dadurch gekennzeichnet, dass** die wenigstens eine Taste (5) in Anpassung der Anordnung des zumindest einen Schaltelements (3) an dem seitlichen Rand der Leiterplatte (4) an einem seitlichen Rand der Haltevorrichtung (1) angeordnet ist.

6. Haltevorrichtung (1) nach einem der vorherigen Ansprüche, **dadurch gekennzeichnet, dass** die wenigstens eine Taste (5) und die Haltevorrichtung (1) aus Kunststoff, insbesondere aus transparentem Kunststoff, ausgebildet sind.

7. Haltevorrichtung (1) nach einem der vorherigen Ansprüche, **dadurch gekennzeichnet, dass** die wenigstens eine Taste (5) und/oder die Haltevorrichtung (1) zumindest eine Vorrichtung zur Führung eines Lichtleiters aufweisen.

8. Haltevorrichtung (1) nach einem der vorherigen Ansprüche, **dadurch gekennzeichnet, dass** das zumindest ein Schalterelement (3) ein SMD-Schalter ist.

9. Elektronisches Gerät mit einer Leiterplatte (4), welches zumindest ein Schalterelement (3) aufweist, mit einer Haltevorrichtung (1) zum Halten einer Baugruppe (2), insbesondere von Displaykomponenten, an der Leiterplatte (4), **dadurch gekennzeichnet, dass** das elektronische Gerät eine Haltvorrichtung (1) nach einem der vorherigen Ansprüche 1 bis 6 aufweist.

10. Elektronisches Gerät nach Anspruch 9, **dadurch gekennzeichnet, dass** das elektronische Gerät ein Mobilfunkgerät, ein PDA, ein Smartphone, ein Notebook, ein Laptop oder ein Organizer ist.

## Claims

1. Retainer device (1), for retaining at least one component (2) on a circuit board (4), comprising at least one switch element (3), **characterized in that** at least one moving button (5) is moulded in one piece on the retainer device (1), wherein in the assembled state of the retainer device (1) on the circuit board (4), the button (5) is assigned to the at least one switch element (3) of the circuit board (4), such that, on operating the button (5), the at least one assigned switch element (3) is operable.

2. Retainer device (1) according to claim 1, **characterized in that** the at least one button (5) is moulded springy on the retainer device (1).

3. Retainer device (1) according to claim 1 or 2, **characterized in that** the retainer device (1) comprises fastening elements (6), in particular snap elements, by which the retainer device (1) is fastenable on the circuit board (4).

4. Retainer device (1) according to one of the previous claims, **characterized in that** the at least one switch element (3) is located on a lateral edge of the circuit board (4).

5. Retainer device (1) according to claim 4, **characterized in that** the at least one button (5) is located on a lateral border of the retainer device (1) in adaptation of the arrangement of the at least one switch element (3) on the lateral edge of the circuit board (4).

6. Retainer device (1) according to one of the previous claims, **characterized in that** the at least one button (5) and the retainer device (1) consist of plastic material, in particular of transparent plastic material.

7. Retainer device (1) according to one of the previous claims, **characterized in that** the at least one button (5) and/or the retainer device (1) comprises at least one device for guiding a light conductor.

8. Retainer device (1) according to one of the previous claims, **characterized in that** the at least one switch element (3) is a SMD switch.

9. Electronic device with a circuit board (4) comprising at least one switch element (3), with a retainer device for retaining an assembly (2), in particular of display components, on the circuit board (4), **characterized in that** the electronic device comprises a retainer device (1) according to one of the previous claims 1 to 6.

10. Electronic device according to claim 9, **characterized in that** the electronic device is a mobile radio device, a PDA, a smartphone, a notebook, a laptop or an organizer.

## Revendications

1. Dispositif de maintien (1) pour maintenir au moins un élément (2) sur une carte à circuit imprimé (4) qui comporte au moins un élément commutateur (3), **caractérisé en ce qu'**au moins une touche mobile (5) est formée d'un seul tenant sur le dispositif de maintien (1), la touche (5) étant associée, lorsque le dispositif de maintien (1) est monté sur la carte à circuit imprimé (4), à l'élément commutateur ou aux éléments commutateurs (3) de la carte à circuit imprimé (4) de telle sorte que l'élément commutateur associé ou les éléments commutateurs associés (3) peuvent être actionnés par un actionnement de la touche (5).

2. Dispositif de maintien (1) selon la revendication 1, **caractérisé en ce que** la ou les touches (5) sont formées de façon à avoir un effet ressort sur le dispositif de maintien (1).

3. Dispositif de maintien (1) selon l'une des revendications précédentes, **caractérisé en ce que** le dispositif de maintien (1) comporte des éléments de fixation (6), notamment des éléments formant cliquets, par lesquels le dispositif de maintien (1) peut être fixé sur la carte à circuit imprimé (4).

4. Dispositif de maintien (1) selon l'une des revendications précédentes, **caractérisé en ce que** le ou les éléments commutateurs (3) sont agencés sur un bord latéral de la carte à circuit imprimé (4).

5. Dispositif de maintien (1) selon la revendication 4, **caractérisé en ce que**, pour être adaptées à l'agencement de l'élément commutateur ou des éléments commutateurs (3) sur le bord latéral de la carte à circuit imprimé (4), la ou les touches (5) sont agencées sur un bord latéral du dispositif de maintien (1).

6. Dispositif de maintien (1) selon l'une des revendications précédentes, **caractérisé en ce que** la ou les touches (5) et le dispositif de maintien (1) sont conçus en plastique, notamment en plastique transparent.

7. Dispositif de maintien (1) selon l'une des revendications précédentes, **caractérisé en ce que** la ou les touches (5) et/ou le dispositif de maintien (1) comportent au moins un dispositif pour guider une fibre optique.

8. Dispositif de maintien (1) selon l'une des revendications précédentes, **caractérisé en ce que** l'élément commutateur ou les éléments commutateurs (3) sont des commutateurs du type composant monté en surface CMS.

9. Appareil électronique avec une carte à circuit imprimé (4), qui comporte au moins un élément commutateur (3), avec un dispositif de maintien pour maintenir un élément (2), notamment des composants d'affichage, sur la carte à circuit imprimé (4), **caractérisé en ce que** l'appareil électronique comporte un dispositif de maintien (1) selon l'une des revendications précédentes 1 6.

10. Appareil électronique selon la revendication 9, **caractérisé en ce que** l'appareil électronique est un appareil de téléphonie mobile, un assistant numérique, un téléphone intelligent, un ordinateur portable, un ordinateur de poche ou un organiseur.
